Europäisches Patentamt

European Patent Office

Office européen des brevets

(19)

(11) EP 1 355 324 A1

## (12) EUROPEAN PATENT APPLICATION
published in accordance with Art. 158(3) EPC

(43) Date of publication:
22.10.2003 Bulletin 2003/43

(51) Int Cl.7: **H01B 5/00**, H01B 1/22, B22F 1/00

(21) Application number: 01273565.0

(22) Date of filing: 22.11.2001

(86) International application number:
PCT/JP01/10228

(87) International publication number:
WO 02/061766 (08.08.2002 Gazette 2002/32)

(84) Designated Contracting States:
AT BE CH CY DE DK ES FI FR GB GR IE IT LI LU
MC NL PT SE TR
Designated Extension States:
AL LT LV MK RO SI

(30) Priority: 24.01.2001 JP 2001053113

(71) Applicant: Kaken Tech Co., Ltd
Katano-shi, Osaka 576-0031 (JP)

(72) Inventors:
• HORI, Shigeo, c/o KAKEN TECH Co., Ltd.
Katano-shi, Osaka 576-0031 (JP)
• FURUI, Hirohiko, c/o KAKEN TECH co., Ltd.
Youkaichi-shi, Shiga 527-0065 (JP)
• KUBOTA, Tadashi
Kokubunji-shi, Tokyo 185-0022 (JP)
• KUBOTA, Yoshiaki
Kokubunji-shi, Tokyo 185-0022 (JP)

(74) Representative: Hoffmann, Eckart, Dipl.-Ing.
Patentanwalt,
Bahnhofstrasse 103
82166 Gräfelfing (DE)

## (54) CONDUCTIVE POWDER AND CONDUCTIVE COMPOSITION

(57) The present invention provides a conductive powder, which can show the high conductivity even in condition that a resin is included, and a conductive composition using the same. In such a conductive powder and a conductive composition, the conductive powder having a convex radically extended and a concave among the convex having the following features;

(1) the convex and concave of the adjoining conductive powders are mutually press-fitted to form a conductive path(first feature).
(2) the shape of the convex is at least one shape selected from the group essentially consisting of the needle shape, a rod shape and a petal shape(second feature).
(3) the electrical resistivity is within a range of $5 \times 10^{-6}$ to $1 \times 10^{-3} \Omega \cdot cm$ in condition that a resin is included (third feature).

Fig.1

(a)

$6 \mu m$

(b)

$3 \mu m$

(c)

$6 \mu m$

**Description**

**TECHNICAL FIELD**

The present invention relates to a conductive powder and a conductive composition, and more particularly to a conductive powder for an electrical industry which can show the highly conductivity (low resistivity) even in condition that a resin is included, and a conductive composition using the same.

**BACKGROUND ART**

Conventionally, a conductive composition constituted from the mixing of a definite amount of a metal powder into a resin, has been widely used in the paste for thick conductor, a conductive adhesive and the like.

As such metal powders used in the conductive composition, for example, a reduced Ag powder made from the reduction reaction from silver nitrate by using the reducing agent such as hydrazine, formaldehyde, and ascorbic acid are known and disclosed in JP S63-179009A, JP H8-92611A, JP H8-92612A, JP H10-88206A, JP H10-88207A, JP 2000-1706A, JP 2000-1707A, JP 2000-129318A, JP 2000-239713, JP 2001-49309A and JP 2001-107101A.

Also, in JP H5-156326A, JP H10-183208A, JP H10-183209A and JP 2000-265202A, a fine non-aggregated Ag powder and a flake type Ag powder made from pyrolysis are disclosed.

Also, in JP H5-81923A, JP H7-109501A, and JP H11-350002A, a fine non-aggregated Ag powder and a flake type Ag powder made from grinding procedure are disclosed.

Moreover, in JP H9-125110A, a dendrite Ag powder made from electrolysis is disclosed.

However, since every conventional metal powders is aiming to conduct via point contacting of the surfaces of the adjoining metal powders, there has been the drawbacks that the contact area is small and the conductive resistance between the conductive substrates in condition that a resin is included, is high.

Further, the conventional metal powders generally show the low conductivity in condition that a resin is included, and many metal powders are required into the resin to obtain the fixed conductive resistance between the conductive substrates. Therefore, there were the drawbacks that the viscosity of the conventional conductive composition becomes high and the handling-ability becomes worse. To improve the handling-ability, the adding quantity is restricted to be the low level and much diluent such as organic solvents are required.

Thus, in the document "Adhesion and Coating Research Seminar in 1987 (Dec.1-2, 1987)" ,Kubota et la, pages 37 to 40, the mixing usage of spherical Ag powder and Ag flake powder(1:3 by weight) were disclosed in consideration of the increasing of the contact points and the filling ratio of a resin regardless of the low contact points.

However, as shown in table 3, the electrical resistivity for the conductive composition obtained from mixing conductive powders is $1.4 \times 10^{-3} \Omega \cdot cm$ which is insufficient value.

Still further, the table 1 shows the formulations of the conductive compositions before drying and after dry curing, that is the resin weight after dry curing was about 9 wt.% and Ag weight after dry curing was about 91 wt.%. Accordingly, estimated from the void value(45%) based on the assuming that the same spheres are filled per unit volume, the filing ratio of the resin was about 1/5.

Therefore, many voids were observed in the conductive composition after drying curing by the optical microscope. Thus, such voids are porous constitution, which are made from the low resin content or high conductive powder, and they are one of the reasons of the low conductive reliability.

In view of the above drawbacks, inventors of the present invention have keenly studied and found that a conductive powder which can show the highly conductivity (low resistivity) even in condition that a resin is included, can be obtained by forming the convex radically extended and a concave among the convex.

Accordingly, it is an object of the present invention to provide a conductive powder which can show the highly conductivity (low resistivity) even in condition that a resin is included, and a conductive composition using the same.

**SUMMARY OF THE INVENTION**

[1] According to the present invention, there is provided a conductive powder having a convex radically extended and a concave among the convex, wherein the said convex and concave of the adjoining conductive powders are mutually press-fitted to form a conductive path, whereby the above-mentioned drawbacks can be solved.

Also, according to the other embodiment of the present invention, there is provided a conductive powder having a convex radically extended and a concave among the convex, wherein the shape of the convex is at least one shape selected from the group essentially consisting of a needle shape, a rod shape or a petal shape, whereby the above-mentioned drawbacks can be solved.

Also, according to the other embodiment of the present invention, there is provided a conductive powder having a convex radically extended and a concave among the convex, wherein the electrical resistivity is within a range of $5\times10^{-6}$ to $1\times10^{-3}\Omega\cdot$cm in condition that a resin is included, whereby the above-mentioned drawbacks can be solved.

Thus, by constituting the conductive powder like this, a convex radically extended and a concave among the convex are easily press-fitted or contacted in condition that the convex is partially inserted in the concave, so that the adjoining conductive powders can contact in a big area respectively. Accordingly, they are similar to a plug and a socket for the electrical wiring and high conductivity (low resistivity) can be obtained in condition that the adding quantity of the conductive powder is relative low level.

[2] According to the other embodiment of the present invention, there is provided a conductive composition using a conductive powder having a convex radically extended and a concave among the convex, wherein the said convex and concave of the adjoining conductive powders are mutually press-fitted to form a conductive path, whereby the above-mentioned drawbacks can be solved.

Also, according to the other embodiment of the present invention, there is provided a conductive composition using a conductive powder having a convex radically extended and a concave among the convex, wherein the shape of the convex is at least one shape selected from the group essentially consisting of a needle shape, a rod shape and a petal shape, whereby the above-mentioned drawbacks can be solved.

Also, according to the other embodiment of the present invention, there is provided a conductive composition using a conductive powder having a convex radically extended and a concave among the convex, wherein the electrical resistivity is within a range of $5\times10^{-6}$ to $1 \times 10^{-3}\Omega\cdot$cm in condition that a resin is included, whereby the above-mentioned drawbacks can be solved.

By constituting the conductive composition like this respectively, high conductivity (low resistivity) can be obtained in condition that the adding quantity of the conductive powder is relative low level.

## BRIEF DESCRIPTION OF THE DRAWINGS

Fig.1 is the electron microscope photos of the conductive powders (3 types) according to the present invention.

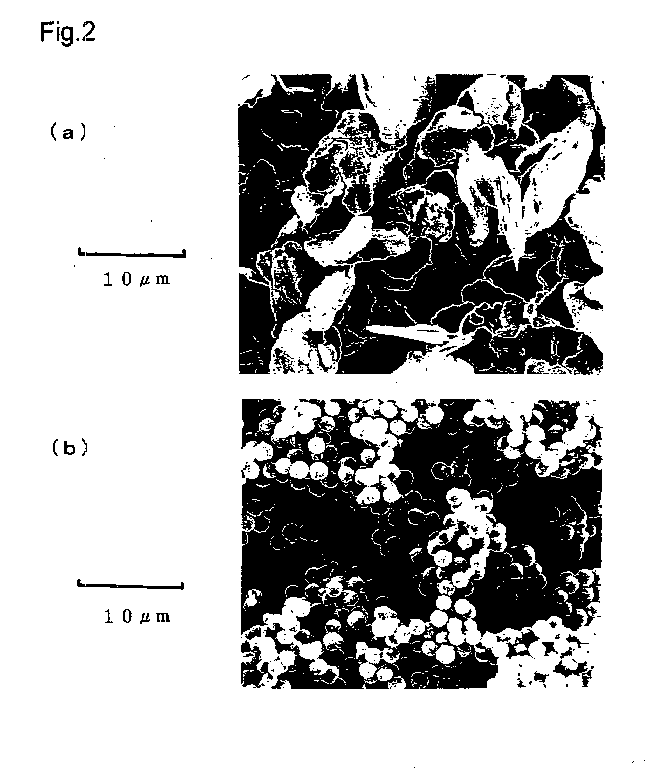

Fig.2 is the electron microscope photos of the conventional conductive powders (2 types).
Fig.3 is a drawing showing the relationship between a resin content and logarithmic number (electrical resistivity) according to the conductive composition.

## DESCRIPTION OF THE PREFERRED EMBODIMENTS

[First embodiment]

First embodiment of the present invention is directed to a conductive powder having a convex radically extended and a concave among the convex, having the following features;

(1) the convex and concave of the adjoining conductive powders are mutually press-fitted to form a conductive path(first feature).
(2) the shape of the convex is at least one shape selected from the group essentially consisting of a needle shape, a rod shape and a petal shape(second feature).
(3) the electrical resistivity is within a range of $5\times10^{-6}$ to $1\times10^{-3}\Omega\cdot$cm in condition that a resin is included according to the measurement method described in example 1(third feature).

Here, it is necessary for the first embodiment 1 to have at least one feature among the above-mentioned 1 to 3 features to solve the conventional problems, but it is more favorable to have more than one feature to solve the conventional problems.

1. Shape

(1) Convex

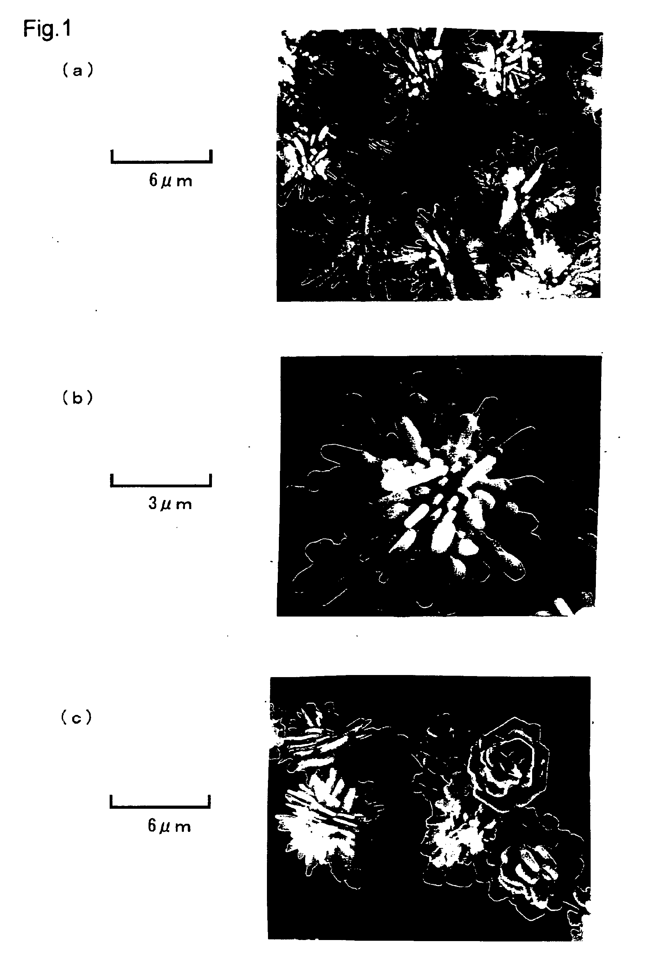

The shape of the convex is favorable at least one shape selected from the group essentially consisting of a needle shape, a rod shape (including a pole shape or a bar shape) or a petal shape as illustratively shown in Fig.1(a), (b) and (c).

The reason of this is that the convex radically extended and the concave among the convex is easily press-fitted between the adjoining conductive powders and the electrical path is easily formed.

Here, the conductive composition including the combination of a Ag powder having the needle type convex, a Ag powder having the rod type convex and a Ag powder having the petal type convex shows the better electrical conductivity since an electrical path are easily formed. More concretely, the conductive composition including the combination of 10 to 50 wt.% of a Ag powder having the needle type convex, 15 to 50 wt.% of a Ag powder having the rod type convex and 20 to 50 wt.% of a Ag powder having the petal type convex based on the total 100% weight, can show the electrical conductivity of $5 \times 10^{-6}$ to $5 \times 10^{-5} \Omega \cdot cm$.

The length of the convex is favorable to exceed 40 % of average radius of the sphere consisting of the closed aspect surrounded by tracing the tip of the convex.

The reason is that such convex has the appropriate length that can secure the press-fitting to the concave, the electrical resistivity becomes much lower and the mechanical stability of the contact area can be improved.

Here, the average particle size of a Ag powder having a needle type convex as shown in Fig.1(a) is about 6 μm and the average length of such convex is 2.6 μm. In addition, the average particle size of a Ag powder having a rod type convex as shown in Fig.1(b) is about 11 μm and the average length of such convex is 3 μm. Further, the average particle size of a Ag powder having a petal type convex as shown in Fig.1(c) is about 5 μm and the average length of such convex is 2 μm.

Thus, such Ag powder can secure the press-fitting to the concave and the electrical resistivity in condition that a resin is included becomes much lower and the mechanical stability of the contact area can be improved.

(2) Concave

The concave (sometimes called as dent) is favorable to be formed between the adjoining convex and to have the dent shape which can press-fit to the convex as illustratively shown in Fig.1(a), (b) and (c).

The reason is that the convex and concave can easily press-fit between the adjoining conductive powders to easily form the electrical path.

Also, the depth (length) of the concave can be expressed by the possessing volume in a conductive powder, namely a void of the concave in a conductive powder. More concretely, it is favorable that the void is to be set within a range of exceeding 40vol.% when the total volume of the expected sphere consisting of the closed carve line connecting the tips of the concave is 100 vol.%.

The reason is that when the void is below 40vol.%, the press-fitting between the convex and concave may become insufficient. On the other hand, when the void is too big, the may be the case where mechanical strength of the conductive powder becomes low.

Accordingly, it is more favorable that the void is to be set within a range of 42 to 70 vol.% and further more favorable that the void is within a range of 45 to 60 vol.%.

Here, the average particle size of the Ag powder having the needle type concave as shown in Fig.1 (a) is 6 μm and its void is 54 vol.%. Also, the average particle size of the Ag powder having the rod type concave as shown in Fig.1 (b) is 11 μm and its void is 49 vol.%. Further, the average particle size of the Ag powder having the petal type concave as shown in Fig.1 (c) is 5 μm and its void is 47 vol.%.

Thus, such Ag powder can secure the press-fitting to the concave and the electrical resistivity in condition that a resin is included becomes much lower and the mechanical stability of the contact area can be improved.

2. Average particle size

Further, it is favorable to set the average particle size of the conductive powder to a value, which is within a range of about 0.1 to 22 μm.

The reason is that, when the average particle size of the conductive powder assumes a value less than 0.1 μm, there arise a case that a large quantity of the conductive powder is required to obtain the good conductivity. On the other hand, when the average particle size of the conductive powder exceeds 22 μm, there arises a case that the mixing and dispersion become difficult and the long making time is required.

Accordingly, it is more favorable to set the average particle size of the conductive powder to a value, which falls within a range of about 1 to 15 μm and it is further more favorable to set such an average particle size to a value, which falls within a range of about 3 to 10 μm.

Here, the average particle size of the conductive powder can be measured by using a laser-type particle counter, or directly computed by taking an image of the conductive powder into an optical microscope, or by computing the average particle diameter based on the image using an image processing apparatus.

3. Type of the conductive powder

As for such type of conductive powder, a single type or a combination of two or more selected from a group consisting of Ag, Ni, Au, Cu, Al, Fe, Zr, Tw, Sn, Pb, Solder and the like.

Among these materials, Ag or Ni is more favorable since they can ensure the favorable conductivity and can provide the relative cheap conductive powders. Also, Ag or Ni is easily dispersed in a resin, especially an epoxy resin or an acryl type resin.

4. Surface treatment

Further, it is favorable to apply the surface treatment to surfaces of the conductive powder, especially the convex of the conductive powder by using the plating, the friction decreasing treatment and the like.

The reason is that applying the surface treatment can increase the mechanical strength of the convex of the conductive powder as well as the conductive powder itself, and the bending or the broken of the convex of the conductive powder can be easily protected.

Here, in the plating process, it is favorable that the thickness of plating is within a range of 0.01 to 3 $\mu$m in consideration of the plating effect and the like.

Also, as for the effect of the surface treatment, the convex and the concave of the adjoining conductive powders are press-fitted by sliding movement easily to form the electrical path.

Such surface treatment agent as favorable samples, are illustrated as silicone oils, fluororesin type surface treatment agents and the several surfactants.

Here, it is favorable that the using quantity of the friction decreasing agent is set to be the value within a range of 0.1 to 30 pbw. based on 100 pbw. of the conductive powder, for example in consideration of the effects of the friction decreasing and the electrically insulating.

5. Electrical properties

(1) Electrical resistivity

Further, it is favorable that the electrical resistivity of the conductive powder in condition that a resin is included is set to be the value within a range of $5\times10^{-6}$ to $1\times10^{-3}\Omega\cdot$cm.

The reason is that when such electrical resistivity is below $5\times10^{-6}\Omega\cdot$cm, there may be the case where the available type of the conductive powder is too restricted or the making profit of the favorable conductive powder dramatically decreases. On the other hand, when such electrical resistivity is over $1\times10^{-3}\Omega\cdot$cm, there may be the case where the conductive resistance when used becomes high and the driving volts also becomes very high.

Accordingly, it is more favorable that the electrical resistivity of the conductive resin in condition that a resin is included, is set to be the value within a range of $5\times10^{-6}$ to $5\times10^{-4}\Omega\cdot$cm, and most favorable that the electrical resistivity is set to be the value within a range of $5\times10^{-6}$ to $1\times10^{-4}\Omega\cdot$cm.

Here, the electrical resistivity of a conductive powder in condition a resin is included, can be measured by the procedure later described in example 1.

(2) Thermal coefficient of resistance (TCR)

Further, it is favorable that thermal coefficient of resistance(TCR) of the conductive powder in condition that a resin is included is set to be the value within a range of $1\times10^{2}$ to $1\times10^{5}$ppm/$^\circ$C.

The reason is that when such TCR value is below $1\times10^{2}$ ppm/$^\circ$C, there may be the case where the available type of the conductive powder is too restricted or the making profit of the favorable conductive powder dramatically decreases. On the other hand, when such TCR value is over $1\times10^{-5}$ppm/$^\circ$C, there may be the case where the conductive resistance when used in the high temperature condition becomes high and the driving volts also becomes very high.

Accordingly, it is more favorable that TCR of the conductive powder is set to be the value within a range of $5\times10^{2}$ to $5\times10^{4}$ ppm/$^\circ$C, and most favorable that TCR of the conductive powder is set to be the value within a range of $1\times10^{3}$ to $1\times10^{4}$ppm/$^\circ$C.

Here, TCR of a conductive powder can be measured by the procedure later described in example 1.

(3) Resistance drift on temperature change

Further, it is favorable that the resistance drift on temperature change is set to be the value within a range of ±5%. The reason is that when the resistance drift on temperature change exceeds the range of ±5%, there may be the case where the conductive resistance when used in the high temperature condition becomes high and the driving volts also becomes very high.

However, when such resistance drift on temperature change is too small, there may be the cases where the available type of the conductive powder is too restricted or the making profit of the favorable conductive powder dramatically decreases.

Accordingly, it is more favorable that the resistance drift on temperature change of the conductive powder is set to be the value within a range of ±0.1 to 3%, and most favorable that the resistance drift on temperature change is set to be the value within a range of ±0.5 to 2%.

Here, the resistance drift on temperature change of the conductive powder can be measured by the procedure later described in example 1.

(4) Noise factor

Further, it is favorable that noise factor of the conductive powder should be lower

Here, it has been known that an electrical noise, which is different from a ground noise is produced when current through the contact points of metal particles. And such electrical noise gives the much effect on signal wave when it is overlapped with small signal voltage and high frequency voltage. Therefore, the electrical noise is one of the alternating voltage induced by several factors accompanying the contact points via potential barrier which controls the current and is a noise having a relative high frequency since carrier density or current was modulated.

However, when such noise factor is too small, there may be the cases where the available type of the conductive powder is too restricted or the making profit of the favorable conductive powder dramatically decreases.

Accordingly, it is favorable that the noise factor of the conductive powder is set to be the value within a range of 10dB or less, more favorable to be the value within a range of -50 to 5dB, and most favorable the noise factor of the conductive powder is set to be the value within a range of -30 to 0dB.

Here, the noise factor of the conductive powder can be measured by the procedure later described in example 1.

6. Producing method

In producing the conductive powder according to the first embodiment, it is favorable to use so called solution reduction method. Namely, it is favorable to produce the conductive powder having the specific shape by deposition from the specific reduction reaction between the metal salt or metal complex in a metal solution and a definite amount of the reducing agent.

(1) Metal salt solution

It is favorable that the metal content in the metal salt solution (including metal complex solution) is set to be the value within a range of 0.1 to 3 mol/litter.

The reason is that when such metal content is below 0.1 mol/litter, there may be the case where the deposited volume of the conductive powder is too small and the making profit of the favorable conductive powder decreases. On the other hand, when such metal content is over 3 mol/litter, the control of the shape of the conductive powder becomes difficult and the making profit of the favorable conductive powder similarly decreases.

Accordingly, it is more favorable that the metal content in the metal salt solution is set to be the value within a range of 0.2 to 2.5 mol/litter, and most favorable the metal content is set to be the value within a range of 0.3 to 2 mol/litter.

Also, it is favorable to adjust the metal content in the metal salt solution according to the formation of the desired convex. For example, when the conductive powder having the needle type and rod type convex should be formed, it is favorable to set the metal content in the metal salt solution to be the value within a range of 0.8 to 2 mol/litter, whereby the desired convex can be easily formed. Further, when the conductive powder having the petal type convex should be formed, it is favorable to set the metal content in the metal salt solution to be the value within a range of 0.3 to 0.7 mol/litter, whereby the desired type convex can be easily formed.

(2) Reducing agent

As for a reducing agent, a single type or a combination of two or more selected from a group consisting of formaldehyde, sodium borohydride, hydrazine, hydrazine compound, hydroquinone, L-ascorbic acid ,pyrocatechol, grape sugar, sodium hypophosphite, sulfate, formic acid, sodium sulfurous anhydride, L-tartaric acid, ammonium formate, rongalite are illustrated.

Among such reducing agents, the single use of L-ascorbic acid or the combined use of L-ascorbic acid and pyrocatechol are more favorable.

Further, it is favorable that the adding quantity of such reducing agent is set to be the value within a range of 0.1 to 3 mol/litter.

The reason is that when such reducing agent level is below 0.1 mol/litter, there may be the case where the deposited volume of the conductive powder is too small and the making profit of the favorable conductive powder decreases. On the other hand, when such reducing agent level is over 3 mol/litter, the control of the shape of the conductive powder becomes difficult and the making profit of the favorable conductive powder similarly decreases.

Accordingly, it is more favorable that the adding quantity of such reducing agent is set to be the value within a range of 0.2 to 2.5 mol/litter, and most favorable that the adding quantity of such reducing agent is set to be the value within a range of 0.3 to 2 mol/litter.

Also, it is favorable to adjust the reducing agent according to the formation of the desired convex. For example, when the conductive powder having the needle type convex should be formed, it is favorable to set the reducing agent content to be the value within a range of 0.8 to 2 mol/litter, whereby the desired needle convex can be easily formed. Further, the conductive powder having the rod type or petal type convex should be formed, it is favorable to set the reducing agent content to be the value within a range of 0.3 to 0.7 mol/litter, whereby the desired convex can be easily formed.

(3) Reducing temperature

Further, it is favorable that the reducing temperature (reaction temperature) is set to be the value within a range of 0 to 30 °C.

The reason is that when such reducing temperature is below 0 °C, there may be the case where the deposited volume of the conductive powder is too small and the making profit of the favorable conductive powder decreases. On the other hand, when such reducing temperature is over 30 °c, the control of the shape of the conductive powder becomes difficult and the making profit of the favorable conductive powder similarly decreases.

Accordingly, it is more favorable that the reducing temperature is set to be the value within a range of 3 to 25 °C, and still more favorable that the reducing temperature is set to be the value within a range of 5 to 20 °C.

(4) Ultrasonic vibration

Further, it is favorable that the ultrasonic vibration is added in the carrying out of the reduction treatment. By carrying out the reduction treatment in this way, cavitations can be produced in the metal salt solution. Accordingly, it is easy to produce the conductive powder having the needle type, rod type and petal type convex by control the deposition direction with the aid of such cavitations.

In adding the ultrasonic vibration, it is favorable that a piezoelectric device, an electrical strain vibration device, a magnetic strain vibration device and the like are used in the frequency of 20 kHz to 3,000 kHz. Moreover, it is favorable to change the frequency of the ultrasonic vibration and adding time of the ultrasonic vibration according to the desired convex shape and length.

[Second embodiment]

Second embodiment of the present invention is directed to a conductive composition using a conductive powder having a convex radically extended and a concave between the convex having the following features;

(1) the convex and concave of the adjoining conductive powders are mutually press-fitted to form a conductive path(first feature).
(2) the shape of the convex is at least one shape selected from the group essentially consisting of the needle shape, a rod shape and a petal shape(second feature).
(3) the electrical resistivity is within a range of $5 \times 10^{-6}$ to $1 \times 10^{-3} \Omega \cdot cm$ in condition that a resin is included according to the measurement method described in example 1(third feature).

1.Conductive powder

(1) Configuration

Since same conductive powders are available as the first embodiment, such explanation here is abbreviated.

(2) Adding quantity 1

As for the adding quantity of a conductive powder into a resin, it is changeable and adjustable according to the several usages. For example, it is favorable that the adding quantity of the conductive powder is set to be the value within a range of 1 to 400 pbw. based on the 100 pbw. of a resin.

The reason is that when such adding quantity is below 1 pbw., there may be the case where the electrical resistivity of the conductive composition becomes too high. On the other hand, when such adding quantity is over 400 pbw., there may be the case where the adhesion strength of the obtainable conductive composition decreases, its viscosity becomes too high and the handling-ability becomes difficult.

Accordingly, it is more favorable that the adding quantity of a conductive powder into a resin is set to be the value within a range of 10 to 100 pbw. based on the 100 pbw. of a resin, and still more favorable that such adding quantity is set to be the value within a range of 20 to 80 pbw..

On the other hand, when a conductive composition is used as an isotropic conductive composition, it is more favorable that the adding quantity of a conductive powder into a resin is set to be the value within a range of 0.1 to 30 pbw. based on the 100 pbw. of a resin.

The reason is that when such adding quantity is below 0.1 pbw., there may be the case where the conductive resistance between the conductive members becomes too high, on the other hand, when such adding quantity is over 30 pbw., there may be the case where the short-circuits adjoining conductive members increase.

Accordingly, when a conductive composition is used as an isotropic conductive composition, it is more favorable that the adding quantity of a conductive powder into a resin is set to be the value within a range of 1 to 20 pbw. based on the 100 pbw. of a resin, and still more favorable that such adding quantity is set to be the value within a range of 3 to 10 pbw..

(3) Adding quantity 2

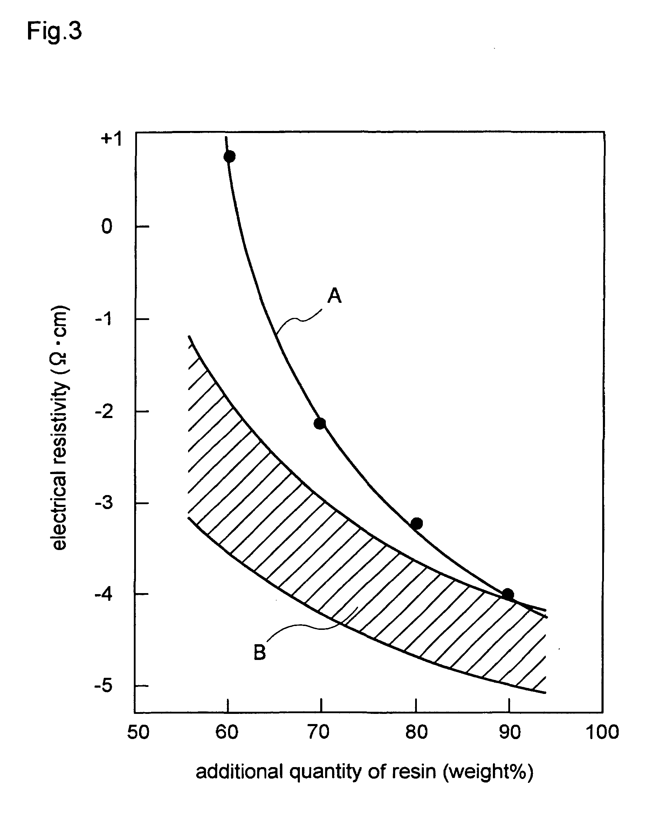

Further, by referring to Fig.3, the effect of resin/conductive powder on electrical resistivity is explained.

In Fig.3, an adding quantity of resin (bis-phenol A type epoxy, weight%) is taken on an axis of abscissas and logarithmic electrical resistivity of the cured conductive composition ($\Omega \cdot cm$) is taken on a axis of ordinates. In Fig.3, line A indicates the electrical property of the conventional conductive composition (comparative example ) and the shaded area defined by line B and line C indicates the electrical property of the present invention's conductive composition ( example A1 to A8).

As can be understood from the Fig. 3, the present invention's conductive composition can show the low electrical property, namely logarithmic electrical resistivity is below -5 when an adding quantity of resin is up to 30 wt. %. When an adding quantity of resin is over 30 wt.%, gradually logarithmic electrical resistivity becomes higher and logarithmic electrical resistivity is still below -3 when an adding quantity of resin is up to 60 wt.%.

On the other hand, the conventional conductive composition can show the low electrical property, namely logarithmic electrical resistivity is below-3 when an adding quantity of resin is up to 20 wt.%. When an adding quantity of resin is over 30 wt.%, logarithmic electrical resistivity becomes rapidly higher and is still more than -2.

Therefore, according to the present conductive composition, when the resin is added in the relative high level, or the conductive powder is added in the relative low level, very low electrical resistivity can be obtained in comparison with the conventional conductive composition.

Accordingly, depending on the usage, it is favorable to set the adding quantity of resin to be the value of about 1 to 65 wt.% or it is favorable to set the adding quantity of the conductive powder to be the value of about 1 to 400 wt.% based on the 100 pbw of a resin (including curing agent).

2. Resin 1

As for a resin constituting a conductive composition, for example, a single type or a combination of two or more selected from a group consisting of an acrylic type resin, a silicone type resin, an ester type resin, an epoxy type resin, an oxetane type resin, a phenol type resin, a cyanate ester type resin, an urethane resin, an acrylic resin, a polyester resin, styrene-butadien-styrene copolymer(SBS resin), styrene-isoprene-styrene copolymer(SIS resin), and styrene-etylene-butylene-styrene copolymer(SEBS resin) are illustrated.

Among these resins, thermosetting type resins are more favorable since these thermosetting type resins have the low viscosity when used, have the good workability, and maintain the suitable electrical resistivity and mechanical properties for a long time.

On the other hand, it is favorable to use a thermoplastic resin such as a SBS resin, a SIS resin and a SEBS resin. By using these thermoplastic resins, the good creep resistance can be obtained since a physical crosslinking structure is formed. Also, such resin could be easily removed by using a solvent and the like when it is attached to the unfavorable site.

Here, when a thermoplastic resin such as a SBS resin, it is more favorable to add 10 to 150 pbw. of a tackifier resins such as a terpenphenol resin, terpen resin and the like based on the 100 pbw. of a thermoplastic resin since the better creep resistance can be obtained.

3. Resin 2

Further, as for a resin constituting a conductive composition, it is favorable to use a non-solvent type resin. It has been known that the air is formed and corrosion and conductive failure have occurred due to the organic solvent included in the conductive composition and residued after the drying process. So, by using a non-solvent type resin, the effect of the organic solvent can be prevented and the air formation and the corrosion between the conductors can be also prevented to obtain the good conductive properties for a long time.

According to the present invention, the good conductive properties can be obtained even in the low using level of the conductive powder in comparison with the conventional conductive composition. So, there is the merit that the proper viscosity and adequate workability as the conductive composition can be obtained even in condition that a non-solvent type resin is used.

Here, as for the type of a non-solvent type resin, an acrylic type resin, a silicone type resin, an ester type resin, an epoxy type resin, an oxetane type resin, a phenol type resin, a cyanate ester type resin, an urethane resin which are setting type resins and its viscosity before adding a conductive powder at room temperature is favorably in a range of 200 to 100,000 mPa· s, more favorably in a range of 500 to 15,000 mPa·s.

4.Additives

As for additives other than the above-mentioned additives, it is favorable to add one type only or a combination of two or more types of additives selected from a group consisting of an antioxidant, an ultraviolet ray absorption agent, metal ion inhibitor, a viscosity improvement agent, an inorganic filler, an organic filler, a carbon fiber, color materials, coupling agent and the like to the conductive composition.

Especially, since the conductive composition is easily oxidized by the presence of the conductive powder, it is favorable to add an amine type antioxidant, a fenole type antioxidant, phosphate type antioxidant and the like, as an antioxidant, in the range of 0.1 to 10 wt% based on the total weight.

5. Producing method

As for the producing method of the conductive composition, it is not limited but, is favorable to use a propeller mixer and spatula and the like for mixing a definite amount of the conductive powders into a resin to produce the conductive composition. Also, it is favorable to heat the part of resin to set its viscosity of 1,000 to 100,000 mPa·s (50°C) to mix the conductive powder and a resin uniformly.

Moreover, it is favorable to apply the surface treatment to surfaces of the conductive powder by using coupling agents in advance to mix the conductive powder into a resin uniformly. For example, it is favorable to mix the conductive powder and 1 to 10 pbw. of 3-aminopropyltrietoxysilane and the like based on the 100 pbw. of the conductive powder and then to add such conductive powder treated by silane coupling agents into a resin.

On the other hand, it is favorable to scatter a definite amount of the conductive powders on to the resin, which is formed as a film in advance or to arrange a conductive powder in the fixed position via an opening plate (filter) to produce a conductive composition. By producing the conductive composition like this, it can protect the convex of the conductive power and reduce the damage since the shear strength to the conductive power can be reduced for stirring the conductive power in the resin.

**Example**

The present invention is explained in further detail based on examples hereinafter. However, the following explanation describes the present invention for an illustration purpose and the content of the present invention is not limited to such a description.

[Example 1]

1. Producing of the conductive powder and its evaluation

(1) Producing of the Ag powder having the needle type convex.

In a 50ml container, 1 mol/litter of Ag nitrate was stored and cooled to obtain the solution having the temperature at 12 to 13 °C by using the cooling instrument

Then, in the same container, 1 mol/litter of L-ascorbic acid was added to carry out the reduction reaction. Subsequently, the deposited material in the container was recovered, washed by water and dried to produce the Ag powder(A1) having the needle type convex.

(2) Producing of the Ag powder having the rod type convex

In a 50ml container, 1 mol/litter of Ag nitrate was stored and cooled to obtain the solution having the temperature 12 to 13 °c by using the cooling instrument

Then, in the same container, 0.5 mol/litter of L-ascorbic acid was added to carry out the reduction reaction. Subsequently, the deposited material in the container was recovered, washed by water and dried to produce the Ag powder(A5) having the rod type convex.

(3) Producing of the Ag powder having the petal type convex

In a 50ml container, 0.5 mol/litter of Ag nitrate was stored and cooled to obtain the solution having the temperature at 12 to 13 °C by using the cooling instrument

Then, in the same container, 0.5 mol/litter of L-ascorbic acid was added to carry out the reduction reaction. Subsequently, the deposited material in the container was recovered, washed by water and dried to produce the Ag powder (A8) having the petal type convex.

(4) Evaluation of the conductive powder

(i) Electrical resistivity (R)

In a container provided with a stirrer, 30 pbw. of epikote 819(manufactured by Yuka Shell Epoxy Kabushiki Kaisha) as a bis-phenol A type epoxy resin and 70 pbw. of three types of Ag powder having the needle type convex are respectively mixed and stirred uniformly to form three paste type formulations respectively.

Then, 20 pbw. of epicure T(manufactured by Yuka Shell Epoxy Kabushiki Kaisha) as an aliphatic amine type curing agent was added to 100 pbw. of the obtained three paste type formulations respectively and was stirred uniformly to produce the three type conductive formulations for testing the electrical resistivity.

Then, the obtained three paste type formulations were respectively screen-coated on the alumina magnetic substrate in a pattern of L:10mm×W:10mm×T:100μm and dried in condition of 180°C×30min. to produce the measurement sample for the electrical resistivity.

Then, by using 4 terminals measurement method, initial electrical resistance of each sample was measured. The obtained resistance values were multiplied by the sectional area (1cm ×0.01cm ) and were divided by the length (1cm) to calculate electrical resistivity (volume resistance, $\Omega$·cm) of the three types Ag powders having the needle type convex and the like.

(ii) Thermal coefficient of resistance (TCR)

The obtained three paste type formulations were respectively screen-coated on the alumina magnetic substrate in a pattern of L:2mm×W:40mm×T:30μm and cured in condition of 180°C×30min. to produce the measurement sample of Thermal Coefficient of Resistance.

Then, by using a programmable oven (furanace) of 25 to 150 °C, measurement samples were heated and its resistance change was measured by (a differential transformer and a digital multimeter). From obtained data, Thermal Coefficient of Resistance(TCR) of the cured conductive composition including three types Ag powders having the needle type convex and the like was calculated.

(iii) Resistance drift on temperature (RD)

The obtained three paste type formulations were respectively screen-coated on the alumina magnetic substrate in a pattern of L:2mm×W:40mm×T:30μm and cured in condition of 180°C×30min. to produce the measurement sample of Resistance drift on temperature.

Then, by using 4 terminals measurement method, initial resistance (Ro ,Q) of each sample was measured and the aged resistance (Rx,Ω) of each sample was measured after allowing to stand for 10 Hrs at 25 °C. From obtained resistances, resistance drift on temperature (%) of the cured conductive composition including the three types Ag powders having the needle type convex and the like was calculated from the following equation.

$$RD (\%) = (Rx\text{-}Ro) /Ro \times 100$$

(iv) Noise factor (NF)

The obtained three paste type formulations were respectively screen-coated on the alumina magnetic substrate in a pattern of L:1mm×W:100mm×T:100μm and cured in condition of 180°C×30min. to produce the measurement sample of noise factor.

Then, by using resistance noise measurement instrument 315C ( manufactured by Quan-Tech Co., in the USA), electrical noise potential ($E_1$) and standard electrical noise potential ($E_0$) of each sample were measured. From obtained data, noise Factor (dB) of the cured conductive composition including the three types Ag powders having the needle type convex and the like was calculated from the following equation.

$$NF (dB) =20Log (E_1/ E_0)$$

2. Producing and Evaluation

(1) Producing of the conductive composition

In a container provided with a stirrer, 15 pbw. of epikote 819 (manufactured by Yuka Shell Epoxy Kabushiki Kaisha) as a bis-phenol A type epoxy resin, 15 pbw. of epikote 152(manufactured by Yuka Shell Epoxy Kabushiki Kaisha) as a phenol novolak type epoxy resin and 5 pbw. of YED-111 as arkylmonogyrcidylether were mixed and stirred uniformly to produce the resin mixture.

Then, 35 pbw. of the obtained resin mixture, 15 pbw. of Ag powder having the needle type convex, 20 pbw. of Ag powder having the rod type convex, and 30 pbw. of Ag powder having the rod type convex were mixed and stirred uniformly to form a paste type formulation.

Then, 20 pbw. of Epicure T (manufactured by Yuka Shell Epoxy Kabushiki Kaisha) as an aliphatic amine type curing agent was added to 100 pbw. of the obtained paste type formulation and was stirred uniformly to produce the conductive composition as example 1.

(2) Evaluation of the conductive composition

(i) Electrical resistivity(R), Thermal coefficient of resistance(TCR), Resistance drift on temperature (RD), and Noise factor (NF)

In the same manners as Ag powder evaluation, electrical resistivity(R), thermal coefficient of resistance(TCR), resistance drift on temperature (RD), and noise factor (NF) were measured.

(ii)Adhesion

The obtained conductive composition was screen-coated on the Cu laminated printed circuit board in a pattern of L:5mm×W:5mm×T:50μm and a Cu chip having the dimension of L:4mm×W:4mm×L:10mm was adhered on the paste. Then, obtained sample was heated in condition at 180°C ×30min., to produce the measurement sample of adhesion. Then, by using (an Amsler type tensile testing machine), the adhesion was measured as the releasing strength (kgf) when the Cu chip was removed from the Cu laminated printed circuit board.

[Example 2]

1. Producing of a conductive powder and its evaluation

(1) Producing of the conductive powder

As shown in table 2, the Ag powder having the needle type convex (A2), the Ag powder having the rod type convex (A6), and the Ag powder having the petal type convex (A7) were obtained in the freely changed deposition conditions as described in example 1.

(2) Evaluation of the conductive powder

The obtained Ag powder was evaluated in the same manner as example 1. The obtained results were shown in tables 2 and 3.

2. Producing of the conductive composition and its evaluation

(1) Producing of the conductive composition

In a container provided with a stirrer, 20 pbw. of epikote 819(manufactured by Yuka Shell Epoxy Kabushiki Kaisha) as a bis-phenol A type epoxy resin, 10 pbw. of epikote 152(manufactured by Yuka Shell Epoxy Kabushiki Kaisha) as a phenol novolak type epoxy resin and 5 pbw. of BGE as arkylmonogrycidylether were mixed and stirred uniformly to produce the resin mixture.
Then, 35 pbw. of the obtained resin mixture, 30 pbw. of Ag powder having the needle type convex (A2), 20 pbw. of Ag powder having the rod type convex (A6), and 30 pbw. of Ag powder having the petal type convex (A7) were mixed and stirred uniformly to form a paste type formulation.
Finally, 20 pbw. of epicure T(manufactured by Yuka Shell Epoxy Kabushiki Kaisha) as an aliphatic amine type curing agent was added to 100 pbw. of the obtained paste type formulation and was stirred uniformly to produce the conductive formulation as example 2.

(2) Evaluation of the conductive composition

The obtained conductive composition was evaluated in the same manner as example 1. The obtained results were shown in table 4.

[Example 3]

1. Producing of a conductive powder and its evaluation

(1) Producing of the conductive powder

As shown in table 2, the Ag powder having the needle type convex (A3) and the Ag powder having the rod type convex (A4) were obtained in the freely changed deposition conditions as described in example 1. Also the Ag powder having the petal type convex (A8) was obtained procedure of example 1.

(2) Evaluation of the conductive powder

The obtained Ag powder was evaluated in the same manner as example 1. The obtained results were shown in tables 2 and 3.

2. Producing of the conductive composition and its evaluation

(1) Producing of the conductive composition

In a container provided with a stirrer, 25 pbw. of epikote 819(manufactured by Yuka Shell Epoxy Kabushiki Kaisha) as a bis-phenol A type epoxy resin, 5 pbw. of epikote 152(manufactured by Yuka Shell Epoxy Kabushiki Kaisha) as a phenol novolak type epoxy resin and 5 pbw. of BGE as arkylmonogrycidylether were mixed and stirred uniformly to produce the resin mixture.

Then, 35 pbw. of the obtained resin mixture, 20 pbw. of Ag powder having the needle type convex (A3), 15 pbw. of Ag powder having the rod type convex (A4), and 30 pbw. of Ag powder having the petal type convex (A8) were mixed and stirred uniformly to form a paste type formulation.

Finally, 20 pbw. of above-described epicure T was added to 100 pbw. of the obtained paste type formulation and was stirred uniformly to produce the conductive formulation as example 3.

(2) Evaluation of the conductive composition

The obtained conductive composition was evaluated in the same manner as example 1. The obtained results were shown in table 4.

[Example 4]

1. Producing of a conductive powder and its evaluation

(1) Producing of the conductive powder

Ni nitrate was used in place of Ag nitrate of example 1, and as shown in table 2, the Ni powder having the needle type convex (N1) and the Ni powder having the petal type convex (N2) were obtained in the freely changed deposition conditions as described in example 1.

(2) Evaluation of the conductive powder

The obtained Ni powder was evaluated in the same manner as example 1. The obtained results were shown in tables 2 and 3.

2. Producing of the conductive composition and its evaluation

(1) Producing of the conductive composition

In a container provided with a stirrer, 15 pbw. of epikote 819, 10 pbw. of epikote 152 and 10 pbw. of YED-111 were mixed and stirred uniformly to produce the resin mixture.

Then, 35 pbw. of the obtained resin mixture, 15 pbw. of Ni powder having the needle type convex (N1), 11 pbw. of Ni powder having the petal type convex (N2), 10 pbw. of the commercially available sphere Ag powder ( average particle size: 1μm) and 29 pbw. of the commercially available flake Ag powder( average particle length: 10μm) were mixed and stirred uniformly to form a paste type formulation.

Finally, 20 pbw. of above-described epicure T was added to 100 pbw. of the obtained paste type formulation and was stirred uniformly to produce the conductive formulation as example 4.

(2) Evaluation of the conductive composition

The obtained conductive composition was evaluated in the same manner as example 1. The obtained results were shown in table 4.

[Example 5]

1. Producing of a conductive powder and its evaluation

(1) Preparation of the conductive powders

As the conductive powders, the same Ni powder(N1) as example 4, the commercially available sphere Ag powder( average particle size: 1μm) and the commercially available flake Ag powder( average particle length: 10μm) were prepared.

2. Producing of the conductive composition and its evaluation

(1) Producing of the conductive composition

In a container provided with a stirrer, 15 pbw. of epikote 819, 10 pbw. of epikote 152 and 10 pbw. of BGE were mixed and stirred uniformly to produce the resin mixture.
Then, 35 pbw. of the obtained resin mixture, 26 pbw. of Ni powder having the needle type convex (N1), 10 pbw. of the commercially available sphere Ag powder ( average particle size: 1μm) and 29 pbw. of the commercially available flake Ag powder( average particle length: 10μm) were mixed and stirred uniformly to form a paste type formulation.
Finally, 20 pbw. of above-described epicure T was added to 100 pbw. of the obtained paste type formulation and was stirred uniformly to produce the conductive formulation as example 5.

(2) Evaluation of the conductive composition

The obtained conductive composition was evaluated in the same manner as example 1. The obtained results were shown in table 4.

[Example 6]

1. Producing of a conductive powder and its evaluation

Preparation of the conductive powders

As the conductive powders, the same Ni powder(N2) as example 4, the commercially available sphere Ag powder( average particle size: 1μm) and the commercially available flake Ag powder( average particle length: 10μm) were prepared.

2. Producing of the conductive composition and its evaluation

(1) Producing of the conductive composition

In a container provided with a stirrer, 15 pbw. of epikote 819, 10 pbw. of epikote 152 and 10 pbw. of BGE were mixed and stirred uniformly to produce the resin mixture.
Then, 35 pbw. of the obtained resin mixture, 26 pbw. of Ni powder having the petal type convex (N2), 10 pbw. of the commercially available sphere Ag powder ( average particle size: 1μm) and 29 pbw. of the commercially available flake Ag powder( average particle length: 10μm) were mixed and stirred uniformly to form a paste type formulation.
Finally, 20 pbw. of above-described epicure T was added to 100 pbw. of the obtained paste type formulation and was stirred uniformly to produce the conductive formulation as example 6.

(2) Evaluation of the conductive composition

The obtained conductive composition was evaluated in the same manner as example 1. The obtained results were shown in table 4.

[Comparative example 1]

1. Preparation of the conductive powders

As the conductive powders, the commercially available sphere Ag powder( average particle size: 1μm) and the commercially available flake Ag powder( average particle length: 10μm) were prepared.

2. Producing of the conductive composition and its evaluation

(1) Producing of the conductive composition

In a container provided with a stirrer, 15 pbw. of epikote 819, 10 pbw. of epikote 152 and 10 pbw. of BGE were mixed and stirred uniformly to produce the resin mixture.

Then, 35 pbw. of the obtained resin mixture, 16.3 pbw. of the commercially available sphere Ag powder ( average particle size: 1µm) and 48.7 pbw. of the commercially available flake Ag powder( average particle length: 10µm) were mixed and stirred uniformly to form a paste type formulation.

Finally, 20 pbw. of above-described epicure T was added to 100 pbw. of the obtained paste type formulation and was stirred uniformly to produce the conductive formulation as comparative example 1.

(2) Evaluation of the conductive composition

The obtained conductive composition was evaluated in the same manner as example 1. The obtained results were shown in table 4.

Table 1

| Formulation | Initial weight (wt.%) | Involatile weight (wt.%) |
|---|---|---|
| Spherical Ag powder (Average size0.5µm) | 17.0 | 22.4 |
| Ag flake powder (Long direction size 4~10µm) | 52.0 | 68.4 |
| Acrylic resin modified by alkylphenol | 7.0 | 9.2 |
| Aceticbutylcarbitol | 24.0 | 0 |
| Total | 100.0 | 100.0 |

Table 2

| Conductive powder | Convex shape | Average size (µm) | Convex length (µm) | Average void (Vol%) |
|---|---|---|---|---|
| Ag powder A 1 | needle | 1.0 | 0.2 | 43 |
| Ag powder A 2 | needle | 6.0 | 2.6 | 54 |
| Ag powder A 3 | needle | 18.4 | 5.2 | 55 |
| Ag powder A 4 | lod | 3.1 | 0.8 | 48 |
| Ag powder A 5 | lod | 11.0 | 3.0 | 49 |
| Ag powder A 6 | lod | 20.2 | 5.7 | 48 |
| Ag powder A 7 | petal | 2.0 | 0.6 | 50 |
| Ag powder A 8 | petal | 5.0 | 2.0 | 47 |
| Ni powder N 1 | needle | 3.4 | 1.0 | 46 |
| Ni powder N 2 | petal | 8.3 | 2.4 | 43 |

Table 3

| Conductive powder | R (Ω·cm) | TCR (ppm/°C) | RD (%) | NF (dB) |
|---|---|---|---|---|
| Ag powder A 1 | $1.0 \times 10^{-5}$ | $4.9 \times 10^3$ | 2.1 | -12.5 |
| Ag powder A 2 | $7.4 \times 10^{-6}$ | $7.0 \times 10^3$ | 1.9 | -10.8 |
| Ag powder A 3 | $1.3 \times 10^{-5}$ | $4.0 \times 10^3$ | 1.8 | - 9.8 |
| Ag powder A 4 | $8.0 \times 10^{-6}$ | $7.5 \times 10^3$ | 1.2 | -20.5 |
| Ag powder A 5 | $2.1 \times 10^{-5}$ | $1.3 \times 10^3$ | 1.0 | -17.0 |
| Ag powder A 6 | $4.1 \times 10^{-5}$ | $2.5 \times 10^3$ | 1.6 | - 5.9 |
| Ag powder A 7 | $7.8 \times 10^{-6}$ | $9.6 \times 10^3$ | 0.8 | -18.7 |
| Ag powder A 8 | $6.6 \times 10^{-6}$ | $4.8 \times 10^3$ | 0.9 | -20.0 |

Table 3   (continued)

| Conductive powder | R (Ω·cm) | TCR (ppm/°C) | RD (%) | NF (dB) |
|---|---|---|---|---|
| Sphere/Flake (1/3 by wt.) | $1.4\times10^{-3}$ | $5.1\times10^{3}$ | 7.2 | +38.7 |
| * R : Electrical resistivity<br>* T C R : Thermal coefficient of resistance<br>* R D : Resistance drift on temperature change<br>* N F : Noise factor | | | | |

Table 4

| Compositions | Example 1 | Example 2 | Example 3 | Example 4 | Example 5 | Example 6 | Comp. Example 1 |
|---|---|---|---|---|---|---|---|
| Ag powder (A1) | 15 | | | | | | |
| Ag powder (A2) | | 30 | | | | | |
| Ag powder (A3) | | | 20 | | | | |
| Ag powder (A4) | | | 15 | | | | |
| Ag powder (A5) | 20 | | | | | | |
| Ag powder (A6) | | 20 | | | | | |
| Ag powder (A7) | | 15 | | | | | |
| Ag powder (A8) | 30 | | 30 | | | | |
| Ni powder (N1) | | | | 15 | 26 | | |
| Ni powder (N2) | | | | 11 | | 26 | |
| Spherical Ag powder | | | | 10 | 10 | 10 | 16.3 |
| Ag flake powder | | | | 29 | 29 | 29 | 48.7 |
| Epikote 819 | 15 | 20 | 25 | 15 | 15 | 15 | 15 |
| Epikote 152 | 15 | 10 | 5 | 10 | 10 | 10 | 10 |
| BGE | | 5 | 5 | | 10 | | 10 |
| YED111 | 5 | | | 10 | | 10 | |
| R (Ω-cm) | $8.0\times10^{-6}$ | $1.1\times10^{-5}$ | $6.8\times10^{-6}$ | $8.3\times10^{-6}$ | $3.5\times10^{-5}$ | $9.0\times10^{-6}$ | $1.4\times10^{-3}$ |
| TCR (ppm/°C) | $5.0\times10^{3}$ | $7.1\times10^{3}$ | $3.5\times10^{3}$ | $1.7\times10^{3}$ | $3.0\times10^{3}$ | $2.3\times10^{3}$ | $5.1\times10^{4}$ |
| RD (%) | 0.8 | 0.9 | 1.0 | 1.3 | 1.2 | 1.0 | 7.2 |
| NF (dB) | -19.5 | -20.7 | -19.3 | -22.0 | -20.8 | -23.0 | 38.7 |

Table 4   (continued)

| Compositions | Example 1 | Example 2 | Example 3 | Example 4 | Example 5 | Example 6 | Comp. Example 1 |
|---|---|---|---|---|---|---|---|
| Adhesion (kgf) | 17.0 | 18.6 | 17.9 | 18.0 | 19.0 | 20.0 | 19.0 |
| * R : Electrical resistivity<br>* T C R : Thermal coefficient of resistance<br>* R D: Resistance drift on temperature change<br>* N F : Noise factor | | | | | | | |

Industrial applicability

As above-described, according to the present conductive powder, the contact are between the adjoining conductive powders becomes bigger and the electrical resistivity becomes lower even in condition that a resin is included,

(1) by providing a convex radically extended and a concave among the convex, wherein the said convex and concave of the adjoining conductive powders being mutually press-fitted, or
(2) by providing a convex radically extended and a concave among the convex, wherein the shape of the convex being at least one shape selected from the group essentially consisting of the needle shape, a rod shape and a petal shape, or
(3) by providing a convex radically extended and a concave among the convex, wherein the electrical resistivity is within a range of $5\times10^{-6}$ to $1\times10^{-3}\Omega\cdot$cm in condition that a resin is included.

Also, according to the present conductive composition, there is provided a conductive composition where the highly conductivity can be shown even in the relative low level of the conductive powder, and a handling ability is good,

(1) by using a conductive powder having a convex radically extended and a concave among the convex, wherein the said convex and concave of the adjoining conductive powders being mutually press-fitted, or
(2) by using a conductive powder having by a convex radically extended and a concave among the convex, wherein the shape of the convex being at least one shape selected from the group essentially consisting of the needle shape, a rod shape and a petal shape, or
(3) by using a conductive powder having a convex radically extended and a concave among the convex, wherein the electrical resistivity is within a range of $5\times10^{-6}$ to $1\times10^{-3}$ $\Omega\cdot$cm in condition that a resin is included.

**Claims**

1.   A conductive powder having a convex radically extended and a concave among the convex, wherein the said convex and concave of the adjoining conductive powders are mutually press-fitted to form a conductive path.

2.   A conductive powder having a convex radically extended and a concave among the convex, wherein the shape of the convex is at least one shape selected from the group essentially consisting of the needle shape, a rod shape and a petal shape.

3.   A conductive powder having a convex radically extended and a concave among the convex, wherein the electrical resistivity is within a range of $5\times10^{-6}$ to $1\times10^{-3}\Omega\cdot$cm in condition that a resin is included.

4.   The conductive powder according to anyone of claims 1 to 3, wherein the average particle size is within a range of about 0.1 to 22 $\mu$m.

5.   The conductive powder according to anyone of claims 1 to 4, wherein the surface treatment is carried out on the surface of the said convex.

6.   The conductive powder according to anyone of claims 1 to 5, wherein the main component of the conductive powder is Ag or Ni.

7. The conductive powder according to anyone of claims 1 to 6, wherein a conductive powder other than the conductive powder having a convex radically extended and a concave among the convex, is included in the content of 1 to 65 wt.% per the total weight.

8. A conductive composition including a conductive powder having a convex radically extended and a concave among the convex and a resin, wherein the said convex and concave of the adjoining conductive powders are mutually press-fitted to form a conductive path.

9. A conductive composition including a conductive powder having a convex radically extended and a concave among the convex and a resin, wherein the shape of the convex is at least one shape selected from the group essentially consisting of a needle shape, a rod shape and a petal shape.

10. A conductive composition including a conductive powder having a convex radically extended and a concave among the convex and a resin, wherein the electrical resistivity is within a range of $5\times10^{-6}$ to $1\times10^{-3}\Omega\cdot$cm in condition that a resin is included.

11. The conductive composition according to anyone of claims 8 to 10, wherein the content of the conductive powder is within a range of 1 to 400 pbw. based on 100 pbw. of a resin.

12. The conductive composition according to anyone of claims 8 to 11, wherein the said resin is a non-solvent type resin.

Fig.1

(a)

|———————|
6 μm

(b)

|———————|
3 μm

(c)

|———————|
6 μm

EP 1 355 324 A1

Fig.2

(a)

├────────────┤
1 0 μ m

(b)

├────────────┤
1 0 μ m

20

Fig.3

## INTERNATIONAL SEARCH REPORT

| International application No. |
| --- |
| PCT/JP01/10228 |

A. CLASSIFICATION OF SUBJECT MATTER
Int.Cl$^7$ H01B 5/00, H01B1/22, B22F 1/00

According to International Patent Classification (IPC) or to both national classification and IPC

B. FIELDS SEARCHED

Minimum documentation searched (classification system followed by classification symbols)
Int.Cl$^7$ H01B 5/00, H01B1/22, B22F 1/00, B22F 9/24

Documentation searched other than minimum documentation to the extent that such documents are included in the fields searched
Jitsuyo Shinan Koho                 1926-1996   Toroku Jitsuyo Shinan Koho  1994-2002
Kokai Jitsuyo Shinan Koho   1971-2002   Jitsuyo Shinan Toroku Koho  1996-2002

Electronic data base consulted during the international search (name of data base and, where practicable, search terms used)
JOIS
DIALOG(WPI/L)

C. DOCUMENTS CONSIDERED TO BE RELEVANT

| Category* | Citation of document, with indication, where appropriate, of the relevant passages | Relevant to claim No. |
| --- | --- | --- |
| Y | JP 11-73818 A (Ricoh Company, Ltd.), 16 March, 1999 (16.03.1999), Claims; Figs. 1 to 9   (Family: none) | 1~12 |
| Y | JP 60-65406 A (Nippon Pillar Packing Co., Ltd.), 15 April, 1985 (15.04.1985), page 2, upper right column, line 11 to page 2, lower left column, line 12; Figs. 2 to 3   (Family: none) | 1~12 |
| Y | JP 61-77278 A (Hitachi Chemical Co., Ltd.), 19 April, 1986 (19.04.1986), page 2, lower right column, line 10 to page 5, upper right column, line 16; Figs. 1 to 4   (Family: none) | 1~12 |
| Y | JP 11-195326 A (Tomogawa Paper Co., Ltd.), 21 July, 1999 (21.07.1999), Par. Nos. [0022] to [0058]   (Family: none) | 3~7,10~12 |
| Y | JP 11-134934 A (Shin-Etsu Polymer Co., Ltd.), 21 May, 1999 (21.05.1999), Claims; Fig. 1   (Family: none) | 7 |

☒ Further documents are listed in the continuation of Box C.          ☐ See patent family annex.

| | |
| --- | --- |
| *     Special categories of cited documents:<br>"A"  document defining the general state of the art which is not considered to be of particular relevance<br>"E"  earlier document but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| 19 February, 2002 (19.02.02) | 26 February, 2002 (26.02.02) |

| Name and mailing address of the ISA/ | Authorized officer |
| --- | --- |
| Japanese Patent Office | |
| Facsimile No. | Telephone No. |

Form PCT/ISA/210 (second sheet) (July 1992)

22

## INTERNATIONAL SEARCH REPORT

| International application No. |
| --- |
| PCT/JP01/10228 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2000-1706 A (Tanaka Kikinzoku Kogyo K.K.), 07 January, 2000 (07.01.2000), Par. Nos. [0010] to [0018]; Figs. 1 to 3 (Family: none) | 1~12 |
| A | Kagaku Kougakukai "Rare Metal Shigen no Yuko Riyo Gijutsu", Kenkyukai, Kagaku Kougaku Symposium Series 31, Rare Metal  Shigen no Yuko Riyo Gijutsu, Kagaku Kougakukai, 01 June 1992 (01.06.1992), pp.160~165 | 1~12 |

Form PCT/ISA/210 (continuation of second sheet) (July 1992)